# EUROPEAN PATENT SPECIFICATION

(11) **EP 4 292 145 B1**
(45) Date of publication and mention of the grant of the patent: **23.09.2026**
(21) Application number: 22708835.8
(22) Date of filing: 10.02.2022
(51) Int. Cl.: H10K 85/60, H01G 9/20, H10K 30/86

(54) **A METHOD FOR MANUFACTURING A COMPOSITION FOR USE AS A TRANSPORT MATERIAL OF A DEVICE, A COMPOSITION OBTAINED BY SUCH A METHOD, A TRANSPORT LAYER COMPRISING SUCH A COMPOSITION, AND AN ELECTRONIC DEVICE COMPRISING SUCH A TRANSPORT LAYER**
VERFAHREN ZUR HERSTELLUNG EINER ZUSAMMENSETZUNG FÜR DIE VERWENDUNG ALS TRANSPORTMATERIAL FÜR EIN BAUTEIL, EINE DURCH DIESES VERFAHREN HERGESTELLTE ZUSAMMENSETZUNG, EINE TRANSPORTSCHICHT DIE EINE SOLCHE ZUSAMMENSETZUNG ENTHÄLT, UND EIN ELEKTRONISCHES GERÄT MIT EINER SOLCHEN TRANSPORTSCHICHT
PROCÉDÉ DE FABRICATION D'UNE COMPOSITION DESTINÉE À ÊTRE UTILISÉE EN TANT QUE MATÉRIAU DE TRANSPORT D'UN DISPOSITIF, COMPOSITION OBTENUE PAR UN TEL PROCÉDÉ, COUCHE DE TRANSPORT COMPRENANT UNE TELLE COMPOSITION ET DISPOSITIF ÉLECTRONIQUE COMPRENANT UNE TELLE COUCHE DE TRANSPORT

(30) Priority: 10.02.2021 SE 2150146
(43) Date of publication of application: 20.12.2023
(73) Proprietor: Linxole AB, 583 33 Linköping (SE)
(72) Inventor: GAO, Feng, 583 28 Linköping (SE); WANG, Feng, 583 33 Linköping (SE); ZHANG, Tiankai, 584 31 Linköping (SE); HU, Zhangjun, 586 65 Linköping (SE)
(74) Representative: AWA Sweden AB
(86) International application number: PCT/EP2022/053289
(87) International publication number: WO 2022/171759

(56) References cited:
- ZHANG WEI ET AL: "Organic Salts as p-Type Dopants for Efficient LiTFSI-Free Perovskite Solar Cells", APPLIED MATERIALS & INTERFACES, vol. 12, no. 30, 30 June 2020 (2020-06-30), US, pages 33751 - 33758, XP055927419, ISSN: 1944-8244, Retrieved from the Internet <URL:http://pubs.acs.org/doi/pdf/10.1021/acsami.0c08322> DOI: 10.1021/acsami.0c08322
- ZHANG WEI ET AL: "Supporting Information Organic Salts as p-Type Dopants for Efficient LiTFSI-free Perovskite Solar Cells", 30 June 2020 (2020-06-30), XP055927860, Retrieved from the Internet <URL:https://doi.org/10.1021/acsami.0c08322> [retrieved on 20220603], DOI: 10.1021/acsami.0c08322
- CHRISTIANS JEFFREY A ET AL: "Tailored interfaces of unencapsulated perovskite solar cells for >1,000 hour operational stability", NATURE ENERGY, NATURE PUBLISHING GROUP UK, LONDON, vol. 3, no. 1, 9 January 2018 (2018-01-09), pages 68 - 74, XP036429314, DOI: 10.1038/S41560-017-0067-Y
- QU JISHUANG ET AL: "Improved performance and air stability of perovskite solar cells based on low-cost organic hole-transporting material X60 by incorporating its dicationic salt", SCIENCE CHINA CHEMISTRY; THE FRONTIERS OF CHEMICAL BIOLOGY AND SYNTHESIS, SCIENCE CHINA PRESS, SIENCE CHINA PRESS, vol. 61, no. 2, 15 December 2017 (2017-12-15), pages 172 - 179, XP036407014, ISSN: 1674-7291, [retrieved on 20171215], DOI: 10.1007/S11426-017-9141-9
- ZHANG JINBAO ET AL: "4- tert -Butylpyridine Free Hole Transport Materials for Efficient Perovskite Solar Cells: A New Strategy to Enhance the Environmental and Thermal Stability", ACS ENERGY LETTERS, vol. 3, no. 7, 19 June 2018 (2018-06-19), pages 1677 - 1682, XP055927497, ISSN: 2380-8195, DOI: 10.1021/acsenergylett.8b00786
- ANONYMOUS: "tetrabutylammonium iodide", 3 June 2022 (2022-06-03), XP055927988, Retrieved from the Internet <URL:http://www.stenutz.eu/chem/solv6.php?name=tetrabutylammonium+iodide> [retrieved on 20220603]

## Description

### TECHNICAL FIELD

The present invention relates to a method for manufacturing a composition for use as a transport material of a device, a composition obtained by such a method, a transport layer comprising such a composition and an electronic device comprising such a transport layer.

### BACKGROUND OF THE INVENTION

A rapidly evolving and developing world has over the last centuries made for a steadily increasing consumption of energy, most of which today is still being provided by non-renewable resources. As we are nearing the limits of our planet's resources, as well as facing environmental consequences from the way that energy is being produced, an interest in the development of sustainable and renewable energy sources is tremendous. Among the different technologies that have gained popularity are solar cells making use of the largest energy source available - the Sun.

Today's Si-based solar cells have surpassed 24% power conversion efficiency (PCE) and dominate the market, although solar cells still account for less than 0.1 % of total world energy production. Major factors in commercializing solar cells are high efficiency and low production cost. Perovskite solar cells can be manufactured by a simple and less expensive manufacturing process, such as printing, compared to Si-based ones. Further, the perovskite solar cells are flexible, light and easily incorporated into other materials, and reach a PCE of >25 %, which makes these types of solar cells an attractive alternative to Si-based solar cells.

The basic principle behind any solar cell is to let incident light excite carriers in a photoactive layer, thus producing current. A typical perovskite device normally consists of five layers, including a transparent conductive oxide, an electron transport layer, a light-absorbing perovskite material, a hole transport layer and a metal electrode. During exposure to sunlight, the perovskite layer absorbs photons to produce excitons (electron-hole pairs), a quasi-particle held together by Coulomb forces. Due to the small exciton binding energy of the perovskite materials, these electron-hole pairs can be easily separated. However, each of the electron and the hole may diffuse randomly within the material and end up at the wrong electrode, where it will recombine with its counterpart thus constituting an energy loss. In order to prevent such energy losses and to promote transport of charges, a hole transport layer (HTL) and an electron transport layer (ETL) are normally incorporated into the structure of the perovskite solar cell devices.

Considering the above, transport layers, such as hole transport layers (HTL) and electron transport layers (ETL), are critical for promoting carrier separation in optoelectronic devices, e.g. perovskites/organic solar cells/light emitting diodes. Organic semiconductors have been widely used as the main part of transport materials. However, additives are also needed to enhance mobility of the organic semiconductors. For example, when 2,2',7,7'-Tetrakis[N,N-di(4-methoxyphenyl)amino]-9,9'-spirobifluorene (Spiro-OMeTAD) is used as hole transport material, the additives Li[(CF₃SO₂)₂N] (LiTFSI) and 4-tert-butylpyridine (tBP) are required. However, compositions comprising additives suffer from drawbacks. In particular, LiTFSI absorbs water, and tBP is volatile, which leads to poor stability causing degradation of the device. Further, a long post-oxidization process (10-24 hours) is required when using the above-mentioned additives, which increases the entire production cycle period. Meanwhile, the rate of post-oxidation largely depends on the environmental humidity and illumination, which need to be carefully controlled. Besides, impurities generated during reactions between the components would possibly prevent achieving high efficiency of devices.

WO2018/105431 describes a photoelectric conversion element, including a first substrate, a first transparent electrode disposed on the first substrate, a hole-blocking layer disposed on the first transparent electrode, an electron-transporting layer that is disposed on the hole-blocking layer and includes an electron-transporting semiconductor on a surface of which a photosensitizing compound is adsorbed, a hole-transporting layer that is connected to the electron-transporting layer and includes a hole-transporting material, and a second electrode disposed on the hole-transporting layer. In the photoelectric conversion element of WO2018/105431, as an output extraction terminal part, a hole-blocking layer having a function of suppressing an increase in a resistance value of ITO that is a material of a first transparent electrode is finely released by laser processing etc., to expose a first transparent electrode. As a result, output electricity of low electric resistance can be extracted. In view of improving conductivity, moreover, an oxidizing agent may be added for changing part of the organic hole-transporting material to a radical cation. However, addition of oxidizing agent induces the above-mentioned disadvantages of moisture sensitivity or/and long post-oxidization process. ZHANG WEI ET AL: "Organic Salts as p-Type Dopants for Efficient LiTFSI-Free Perovskite Solar Cells",APPLIED MATERIALS & INTERFACES, vol. 12, no. 30, 30 June 2020 (2020-06-30), pages 33751-33758, discloses a composition comprising an organic semiconductor, a radical compound and a polar compound.

In view of the above, there is a need for an improved method for manufacturing a composition that may be used as a transport material of an electronic device, wherein the drawbacks of the prior art are eliminated.

### SUMMARY OF THE INVENTION

The present invention thus discloses a method for manufacturing a composition for use as a transport material of an electronic device, the method comprising the steps of:
a) providing a first organic semiconductor;
b) providing a radical compound;
c) providing a polar compound having a dipole moment of at least 6.0 debye (D);
d) mixing the first organic semiconductor, the radical compound and the polar compound to obtain the composition.

As is evident from the above, the method according to the present invention does not require addition of a radical initiator, such as an oxidizing agent, in order to form the radical compound. The method of the present invention thus eliminates the need for post-oxidization process, which is a rather time-consuming step, requiring the reaction time of at least 10h. Further, the method of the present invention provides the composition having improved stability against moisture and heat. The method of the present invention also provides a composition having virtually no impurities, which is impossible according to the methods previously described in the art, since addition of a radical initiator and tBP inevitably leads to formation of such impurities. Finally, the method of the present invention requires a lower amount of additives.

The ratio between the first organic semiconductor, the radical compound, and the polar compound in step d) may be from 1:0.01:0.03 to 1:0.3:0.9 by molar ratio, preferably from 1:0.05:0.15 to 1:0.08:0.25, more preferably 1:0.07:0.2 by molar ratio. These ratios should be compared with conventional ratio in the range from 1:0.5:2 to 1:0.6:4. Considering the above, the method according to the present invention is costefficient. Step d) may be performed by mixing the first organic semiconductor, the radical compound and the polar compound according to the ratio defined above and dissolving the mixture in a suitable solvent or a solvent mixture. Alternatively, each of the first organic semiconductor, the radical compound and the polar compound may be dissolved in a suitable solvent or a solvent mixture, and subsequently combined.

The first organic semiconductor may be a conjugated small molecule or a conjugated polymer, such as triphenylamine, thiophene or triphenylphosphine. For example, the first organic semiconductor may be selected from the group consisting of 2,2',7,7'-Tetrakis[N,N-di(4-methoxyphenyl)amino]-9,9'-spirobifluorene (Spiro-OMeTAD), Poly[bis(4-phenyl)(2,4,6-trimethylphenyl)amine] (PTAA), poly(3-hexylthiophene) (P3HT), 3,3'-(2,7-bis(bis(4-methoxyphenyl)amino)-9H-fluorene-9,9-diyl)bis(N-ethyl-N,N-dimethylpropan-1-aminium) bis(trifluoromethanesulfonyl)imide (X44), octakis(4-methoxyphenyl)spiro[fluorene-9,9'-xanthene]-2,2',7,7'-tetraamine) (X60), indacenodithienothiophene-methoxytriphenylamine (IDTT-TPA), poly[N-90-heptadecanyl-2,7carbazole-alt-3,6-bis(thiophen-5-yl)-2,5-dioctyl-2,5-dihydropyrrolo[3,4]pyrrole-1,4-dione] (PCBTDPP), phenyl-dipyrenylphosphine oxide (POPy2) and mixtures thereof. Some of the chemical structures of the compounds that may be used as the first organic semiconductor are depicted below.

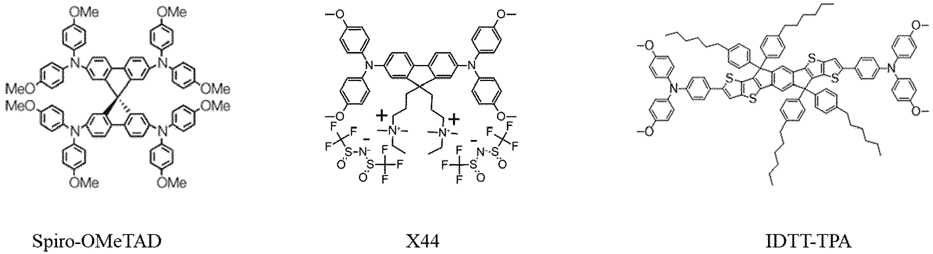

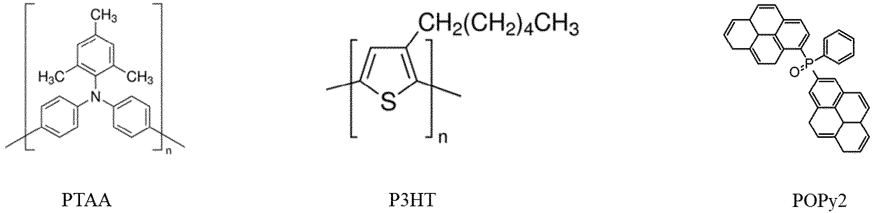

The important feature of the present invention is that step b) of providing a radical compound occurs before step d), i.e. the radical compound is not formed *in situ,* as has been done in the methods according to the prior art, but is formed separately and added to the composition. This step eliminates the need for adding a radical initiator and tBP to the composition, and consequently also eliminates the need for the post-oxidation treatment. Since no radical initiator and tBP are added, no byproducts are formed, which offers the advantage of obtaining stable composition being free of impurities.

Step b) may be performed according to the following procedure. A second organic semiconductor may be dissolved in an anhydrous first solvent in an inert atmosphere. The second organic semiconductor may be same as or different from the first organic semiconductor. A radical initiator, e.g. an organic salt, may be added at ambient temperature. The mixture may be stirred at room temperature for 24 h, leading to formation of the radical compound. The first solvent may be dichloromethane (DCM). The radical initiator may be silver(I) bis(trifluoromethanesulfonyl)imide. Step b) may further comprise additional procedures such as filtration, dilution, evaporation, precipitation or the like.

The present invention further relates to a composition obtained by the method disclosed above.

The composition of the present invention may be used as a transport material in an electronic device, wherein the transport material may be hole transport material or electron transport material. By the term "hole transport material" is understood a material being able to collect and transport holes created when an electron is excited from HOMO to LUMO towards the cathode. By the term "electron transport material" is understood a material promoting a flow of electrons to move towards the anode.

When the composition of the present invention is intended to be used as a hole transport material, the radical compound may be a radical cation pair being abbreviated as R₁^{a•+}(I₁^{b-})_{c}, wherein a=b·c, wherein a and b are valence states, R₁^{a•+} is a radical cation of a second organic semiconductor, and I₁^{b-} is a first counter anion. The second organic semiconductor at least consists of a conjugated backbone, such as triphenylamine or thiophene, which may be the same as or different from the first organic semiconductor. In particular, the second organic semiconductor may be selected from the group consisting of 2,2',7,7'-Tetrakis[N,N-di(4-methoxyphenyl)amino]-9,9'-spirobifluorene (Spiro-OMeTAD), Poly[bis(4-phenyl)(2,4,6-trimethylphenyl)amine] (PTAA), poly(3-hexylthiophene) (P3HT), 3,3'-(2,7-bis(bis(4-methoxyphenyl)amino)-9H-fluorene-9,9-diyl)bis(N-ethyl-N,N-dimethylpropan-1-aminium) bis(trifluoromethanesulfonyl)imide (X44), octakis(4-methoxyphenyl)spiro[fluorene-9,9'-xanthene]-2,2',7,7'-tetraamine) (X60), indacenodithienothiophene-methoxytriphenylamine (IDTT-TPA), poly[N-90-heptadecanyl-2,7carbazole-alt-3,6-bis(thiophen-5-yl)-2,5-dioctyl-2,5-dihydropyrrolo[3,4]pyrrole-1,4-dione] (PCBTDPP) and mixtures thereof. The chemical structures of exemplary radical cations are shown below.

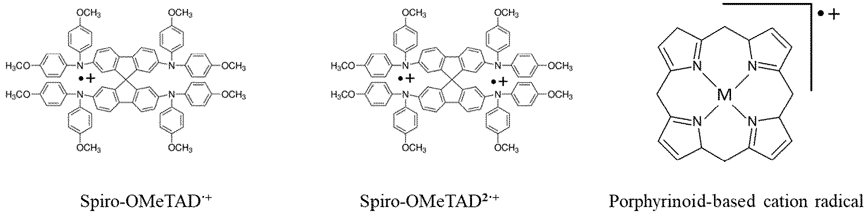

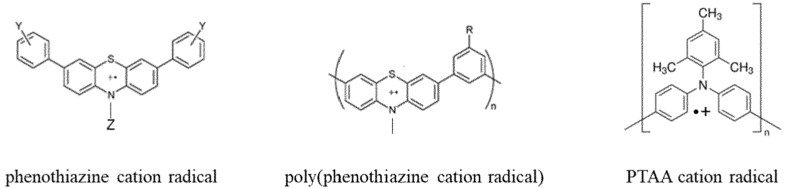

The first counter anion may be an organic or an inorganic ion. The first counter anion may be selected from the group consisting of halogen anions (X⁻), bis(trifluoromethylsulfonyl)imide anion (TFSI⁻), hexafluorophosphate (PF₆⁻), tetrafluoroborate (BF₄⁻), triflate (CF₃SO₃⁻) and mixtures thereof.

According to another embodiment, the radical compound may be four-armed triarylamine (TAA)-based radical molecules (M1 and M2), star-shaped TAA-based radical molecules (M3 and M4) and/or linear TAA-based radical molecules (M5 and M6).

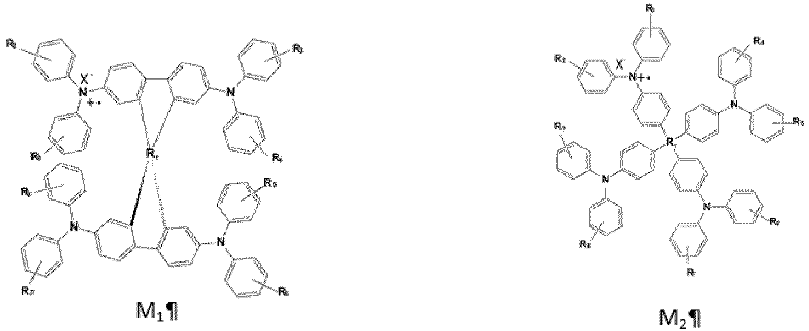

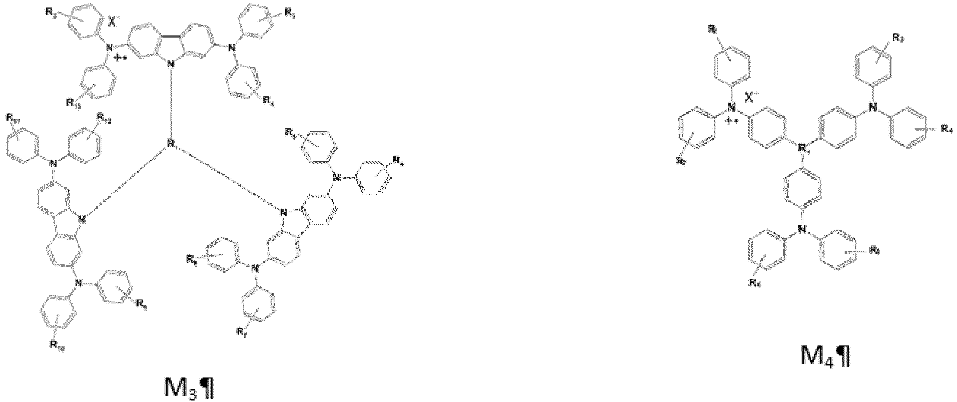

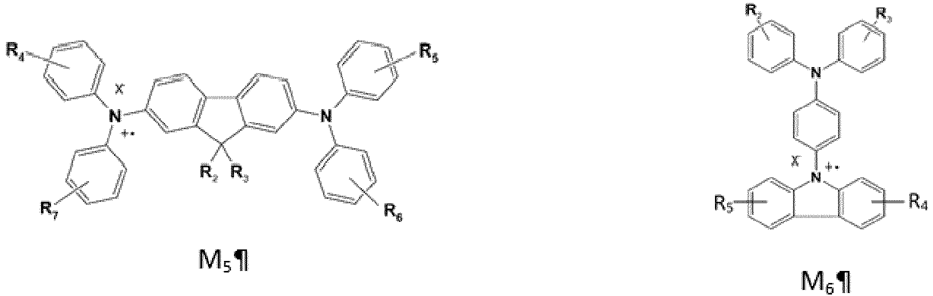

R₁ may be alkyl, aromatic or heteroaromatic groups. R₂, R₃, R₄, R₅, R₆, R₇, R₈, R₉, R₁₀, R₁₁, R₁₂, and R₁₃ are independently R, -OR, or -NR₂ substituents, where R is a halide, alkyl, aromatic or heteroaromatic group. X⁻ counter anion may be selected from the group consisting of halogen anions, bis(trifluoromethylsulfonyl)imide anion (TFSI⁻), hexafluorophosphate (PF⁶⁻), tetrafluoroborate (BF⁴⁻), triflate (CF₃SO₃⁻) and mixtures thereof. The radical cation can be individually or simultaneously presented at any of the N atoms in the above structures. It should be noted that M1 does not include the molecule with -OCH₃ group at all R₁-R₈ with the para position and C at the R₉ position, where X⁻ is TFSI⁻.

Alternatively, when the composition of the present invention is intended to be used as an electron transport material, the radical compound may be a radical anion pair being abbreviated as R₂^{d•-}(I₂^{e+})_{f}, wherein d=e·f, wherein d and e are valence states, R₂^{d•-} is a radical anion of a third organic semiconductor, and I₂^{e+} is a first counter cation. The third organic semiconductor is preferably different from the first and/or the second organic semiconductor. The first counter cation may be an alkali metal cation, such as Na⁺ or K⁺. Possible chemical structures of radical anions are illustrated below.

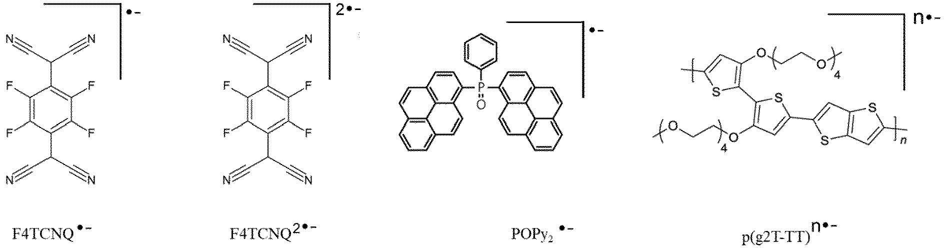

The composition according to the present invention further comprises a polar compound having a dipole moment of at least 6.0 D. The dipole moment uses electric dipole moment to measure the polarity within a molecule. Such an electric dipole moment arises whenever there is a separation of positive and negative charges. The bond dipole moment µ is defined as: $μ = δ ⋅ d$ wherein δ is the charge in 10⁻¹⁰ statcoulomb, and d is the distance between the partial charges δ⁺ and δ⁻ in Ångströms.

The polar compound of the present invention may be an organic salt or a neutral polar molecule. The organic salt may in turn be a small organic molecule, a multivalent organic salt, a polymer electrolyte or an inner salt. By the term "small organic molecule" is understood an organic compound having low molecular weight (< 900 daltons). In particular, the organic salt may be abbreviated as (A^{×+})_{y}(B^{z-})_{w}, wherein x·y=w·z, wherein x and z are valence states, A^{×+} is a second cation, and B^{z-} is a second anion.

The second cation A^{×+} may be an alkyl or an aromatic organic cation. Preferably, the second cation A^{×+} is represented by the formula RNH₃⁺, wherein R is an alkyl group or an aromatic group. In particular, the second cation may be tert-butyl-pyridinium (tBP based cation).

The second anion B^{z-} may be same as or different from the first counter anion I₁⁻. In particular, the second anion may be selected from the group consisting of TFSI⁻, I⁻, SP₆⁻, ClO₄⁻, PF₆⁻, BF₄⁻, CF₃SO₃⁻ and mixtures thereof.

When the polar compound is an organic salt, the dipole moment may be at least 15 D, preferably at least 20 D. The polar compound may be a multivalent organic salt or a polymer electrolyte selected from the group consisting of the following chemical compounds:

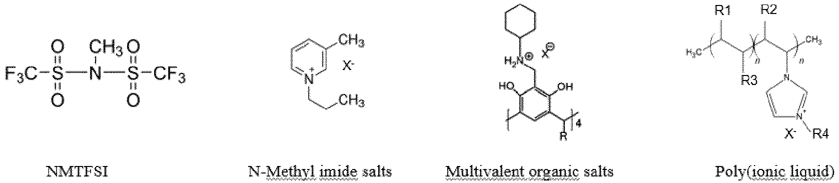

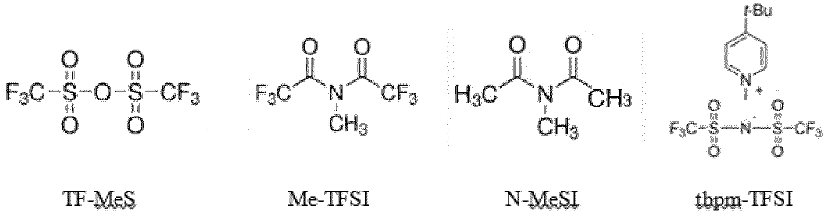

The inner salt, also called zwitterion, is a molecule that contains an equal number of positively and negatively charged functional groups. The inner salt may be selected from the group consisting of L-carnitine inner salt (I), 2,7-bis(1,3,2-dioxaborolan-2-yl)-9,9-dioctylfluorene with 2,7-dibromo-9,9-bis((N,N-dimethylamino)ethanyl)fluorene based zwitterion (II), 2,2'-(4,4'-sulfonylbis(1,4-phenylene)bis(oxy))bis(N,N-dimethylethanamine) based zwitterion (III), *N¹,N¹,N⁶,N⁶-*tetramethylhexane-1,6-diamine based zwitterion (IV) or mixtures thereof, as depicted below.

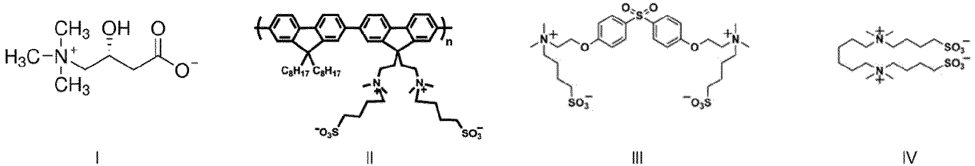

As mentioned above, the composition of the present invention does not require post-oxidization, which shortens the overall production cycle. Further, the composition has enhanced stability against moisture and heat.

The present invention further discloses a transport layer for an electronic device, the transport layer comprising a composition comprising a first organic semiconductor, a radical compound, and a polar compound having a dipole moment of at least 6.0 D. The features of the components of the composition are the same as have been described above.

The transport layer according to the present invention may be prepared by dissolving the composition described above in a solvent, such as chlorobenzene, toluene, chloroform, 1,2-dichloroethane, 1,1,2,2-tetrachloroethane, or mixtures thereof, and applying the solution onto an electronic device by any suitable deposition technique known in the art, such as spin-coating, spray-coating, or roll-to-roll process, thus obtaining a thin film of the transport layer.

It should be noted that the transport layer according to the present invention is advantageous since it is substantially free of impurities and additives that are sensitive to moisture and heat, thus prolonging service life of the electronic device. Further, the transport layer of the present invention does not require post-oxidization process, thus shortening the manufacturing cycle of the electronic device.

The transport layer according to the present invention may be a hole transport layer (HTL). In this case, the radical compound is a radical cation pair that may be abbreviated as R₁^{a•+}(I₁^{b-})_{c}, wherein a=b·c, wherein a and b are valence states, R₁^{a•+} is a radical cation of a second organic semiconductor, and I₁^{b-} is a first counter anion. The radical cation as well as the first counter anion have been described in detail above.

Alternatively, the transport layer according to the present invention may be an electron transport layer (ETL). In this case, the radical compound is a radical anion pair that may be abbreviated as R₂^{d•-}(I₂^{e+})_{f}, wherein d=e·f, wherein d and e are valence states, R₂^{d•-} is a radical anion of a third organic semiconductor, and I₂^{e+} is a first counter cation. The radical anion as well as the first counter cation have been described in detail above.

The present invention further discloses an electronic device comprising at least one transport layer according to the above. Thus, the electronic device may comprise one transport layer according to the present invention, wherein the transport layer may be either HTL or ETL. Alternatively, the electronic device may comprise two transport layers according to the present invention, wherein one layer is ETL, and the other layer is HTL. The remaining components of the electronic device are well known to the person skilled in the art and do not form a part of the present invention.

The electronic device may be an organic solar cell/light-emitting diode module or a perovskite solar cell/light-emitting diode module or dye-sensitized solar cells (DSSCs). The solar cell devices according to the present invention deliver comparable power conversion efficiency as those known in the art. Further, the solar cell devices of the present invention demonstrate improved stability against moisture and heat, thus prolonging the service life of the solar cell devices.

### BRIEF DESCRIPTION OF THE DRAWINGS

Embodiments of the invention will now be described by way of example with reference to the accompanying drawings, of which:
Fig. 1 shows conductivity measurement on an HTL comprising the composition of the present invention;
Figs. 2a - c depicts the morphology of the HTL of the present invention;
Fig. 3 illustrates J-V curves of perovskite solar cell devices comprising different HTL compositions.
Figs. 4-7 represent the density-voltage (J-V) curves of perovskite solar cells comprising compositions according to the present invention using different polar compounds.

### DETAILED DESCRIPTION OF THE INVENTION

The composition for use as a transport material of an electronic device was prepared. As a first organic semiconductor, Spiro-OMeTAD was used, obtained from Sigma-Aldrich. A radical compound was Spiro-OMeTAD^{2•+}(TFSI⁻)₂, prepared as follows. Spiro-OMeTAD (1.26 g, 1 mmol) and 20 mL anhydrous dichloromethane (DCM) were added into an oven-dried 50 mL flask with stirring under nitrogen atmosphere. Silver(I) bis(trifluoromethanesulfonyl)imide (0.39 g, 1 mmol) was added over 5 min at ambient temperature. The flask was evacuated and backfilled with nitrogen. The mixture was stirred at room temperature for 24 h, followed by dilution with DCM. A gray precipitate of silver (0) was filtered off by a fritted filter, and the solvent from the filtrate was removed to leave a dark solid. The solid was dissolved in a minimal amount of DCM and precipitated in dry diethyl ether. The resulting fine, extremely dark powder Spiro-OMeTAD^{2•+}(TFSI⁻)₂ was collected via filtration through a fritted filter. Consequently, the radical cation according to an exemplary embodiment of the present invention was the radical cation is Spiro-OMeTAD^{•+}, illustrated above, and the first counter anion was TFSI⁻. As a polar compound, tBPM⁺TFSI⁻ was used, prepared as follows. tBP (1.35 g, 10 mmol) and anhydrous acetonitrile (10 mL) were added into a 100 mL flask with stirring under nitrogen atmosphere. lodomethane (4.2 g, 30 mmol) in anhydrous acetonitrile (2.5 mL) was added by a dropping funnel over 30 min at ambient temperature. The mixture was refluxed for 16 h, then allowed to cool to room temperature. After removal of solvent under reduced pressure, the crude product 4-tert-butyl-1-methylpyridin-1-iumiodide was obtained, which was purified by recrystallization. To a heated solution of 4-tert-butyl-1-methylpyridin-1-iumiodide (1.39 g, 5 mmol) in 5 mL methanol, a solution of silver(I) bis(trifluoromethanesulfonyl)imide (3.88 g, 10 mmol) in acetonitrile (5 mL) was added dropwise with stirring. A thick yellow precipitate of silver(I) iodide formed. The precipitate was filtered off and rinsed with methanol, and the solvent from the filtrate was removed to leave a waxy solid tBPM⁺TFSI⁻. Consequently, the second cation was tBPM⁺, and the second anion was TFSI⁻. The first organic semiconductor, the radical compound and the polar compound were used in proportion 1:0.07:0.2 by molar ratio, respectively. Each of the first organic semiconductor, the radical compound and the polar compound were dissolved in chlorobenzene (CB) and 1,1,2,2-tetrachloroethane (TCE, 10 v/v %) at room temperature, and the solutions were combined. It is further conceivable to mix the components and then dissolve the mixture in the above-mentioned solvent.

Further, a reference composition was obtained, comprising only the first organic semiconductor Spiro-OMeTAD and the radical compound Spiro-OMeTAD^{2•+}(TFSI⁻)₂, in order to demonstrate the function of the polar compound in the composition of the present invention. The reference composition was prepared by mixing the first organic semiconductor and radical compound in molar ratio of 1:0.07.

Finally, both the composition of the present invention and the reference composition were compared to pristine first organic semiconductor in the form of Spiro-OMeTAD.

Each of the composition of the present invention, the reference composition and pristine Spiro-OMeTAD were dissolved in a mixture of chlorobenzene (CB) and 1,1,2,2-tetrachloroethane (TCE, 10 v/v %), obtaining a 0.07M solution. The solutions were spin-coated directly onto indium tin oxide (ITO) layer at a spin speed of 5000 rmp/min, thus forming an HTL. The thickness of the films was approximately 100 nm. A gold electrode having thickness of approximately 60 nm was evaporated on top of the HTL.

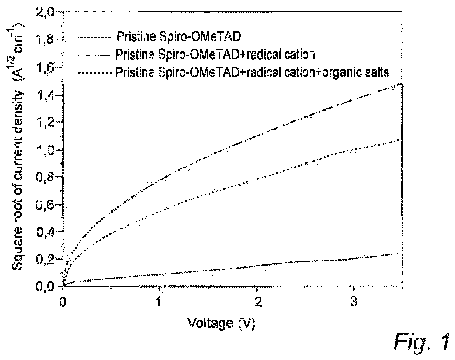

Conductivity measurements were performed using a source meter. The results are summarized in Fig. 1. As may be seen, pristine Spiro-OMeTAD demonstrated poor conductivity, which significantly improved when the radical compound and the polar compound were added.

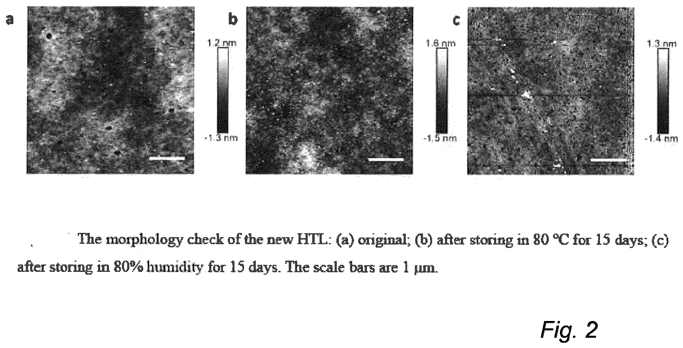

Fig. 2 illustrates the morphology study of the HTL of the present invention using atomic force microscopy (AFM). As may be seen in Fig. 2, the HTLs with different compositions has little variation in morphology.

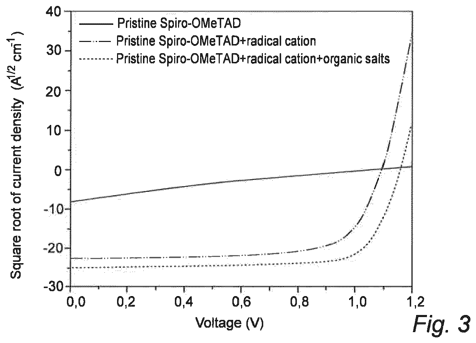

Finally, the photovoltaic performance of devices was obtained from the J-V curves, collected under standard test conditions at an irradiance of 1000W/m², a temperature of approximately 25°C and air mass of 1.5. The results are summarized in Fig. 3. As depicted in Fig. 3, the three different HTLs exhibit different solar cell performance. Pristine Spiro-OMeTAD demonstrated low open-circuit voltage and low fill factor due to the poor conductivity. With the radical compound Spiro-OMeTAD^{2•+}(TFSI⁻)₂, the open-circuit voltage and fill factor increase a lot because of the ameliorated conductivity. Then, with the addition of the polar compound, tBPM⁺TFSI⁻, the open-circuit voltage, short-circuit current density and fill factor all increase further. This confirms that the polar compound facilitates the hole collection and extraction.

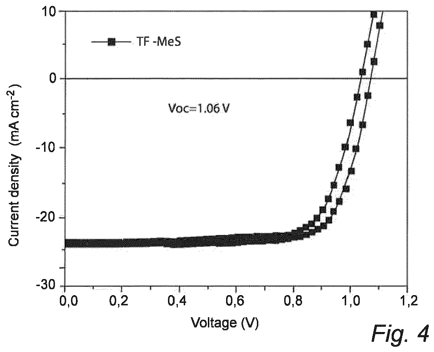

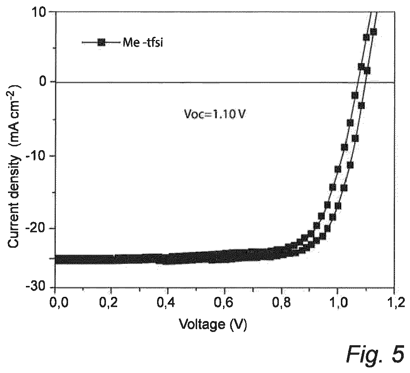

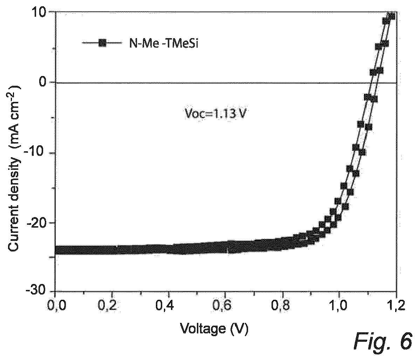

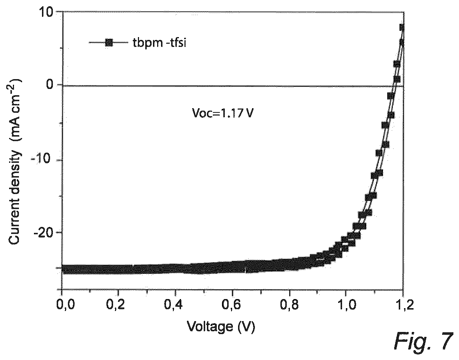

Figs. 4-7 represent the density-voltage (J-V) curves of perovskite solar cells comprising compositions according to the present invention using different polar compounds. The results confirm that polar compounds having a high dipole moment are needed for high-efficiency performance.

Although the present invention has been described with reference to various embodiments, those skilled in the art will recognize that changes may be made without departing from the scope of the invention. It is intended that the detailed description be regarded as illustrative and that the appended claims are intended to define the scope of the invention.

## Claims

1. A method for manufacturing a composition for use as a transport material of an electronic device, said method comprising the steps of:
a) providing a first organic semiconductor;
b) providing a radical compound;
c) providing a polar compound having a dipole moment of at least 6.0 debye (D);
d) mixing said first organic semiconductor, said radical compound and said polar compound to obtain said composition.

2. The method according to claim 1, wherein said first organic semiconductor is a conjugated small molecule or a conjugated polymer.

3. The method according to claim 1 or 2, wherein said first organic semiconductor comprises triphenylamine, thiophene or triphenylphosphine.

4. The method according to any one of the preceding claims, wherein said first organic semiconductor is selected from the group consisting of 2,2',7,7'-Tetrakis[N,N-di(4-methoxyphenyl)amino]-9,9'-spirobifluorene (Spiro-OMeTAD), Poly[bis(4-phenyl)(2,4,6-trimethylphenyl)amine] (PTAA), poly(3-hexylthiophene) (P3HT), 3,3'-(2,7-bis(bis(4-methoxyphenyl)amino)-9H-fluorene-9,9-diyl)bis(N-ethyl-N, N-dimethylpropan-1-aminium) bis(trifluoromethanesulfonyl)imide (X44), octakis(4-methoxyphenyl)spiro[fluorene-9,9'-xanthene]-2,2',7,7'-tetraamine) (X60), indacenodithienothiophene-methoxytriphenylamine (IDTT-TPA), poly[N-90-heptadecanyl-2,7carbazole-alt-3,6-bis(thiophen-5-yl)-2,5-dioctyl-2,5-dihydropyrrolo[3,4]pyrrole-1,4-dione] (PCBTDPP), phenyl-dipyenylphosphine oxide (POPy2) and mixtures thereof.

5. The method according to any one of the preceding claims, wherein said radical compound is a radical cation pair being abbreviated as R₁^{a•+}(I₁^{b-})_{c}, wherein a=b·c, wherein a and b are valence states, R₁^{a•+} is a radical cation of a second organic semiconductor, and I₁^{b-} is a first counter anion.

6. The method according to claim 5, wherein said first counter anion is selected from the group consisting of halogen anions (X⁻), bis(trifluoromethylsulfonyl)imide anion (TFSI⁻), hexafluorophosphate (PF₆⁻), tetrafluoroborate (BF₄⁻), triflate (CF₃SO₃⁻) and mixtures thereof.

7. The method according to any one of claims 1-4, wherein said radical compound is a triarylamine (TAA)-based radical compound.

8. The method according to any one of claims 1-4, wherein said radical compound is a radical anion pair being abbreviated as R₂^{d•-}(I₂^{e+})_{f}, wherein d=e·f, wherein d and e are valence states, R₂^{d•-} is a radical anion of a third organic semiconductor, and I₂^{e+} is a first counter cation.

9. The method according to any one of the preceding claims, wherein said polar compound is an organic salt, an inner salt or a neutral polar molecule.

10. The method according to claim 9, wherein said organic salt is a small organic molecule, a multivalent organic salt or a polymer electrolyte.

11. The method according to claim 10, wherein said organic salt is abbreviated as (A^{×+})_{y}(B^{z-})_{w}, wherein x·y=w·z, wherein x and z are valence states, A^{×+} is a second cation, and B^{z-} is a second anion.

12. The method according to claim 11, wherein said second cation A^{x+} is an alkyl or an aromatic organic cation.

13. A composition for use as a transport material of an electronic device, said composition being manufactured according to the method according to any one of the preceding claims.

14. A transport layer for an electronic device, said transport layer comprising a composition according to claim 13.

15. An electronic device comprising at least one transport layer according to claim 14.

## Patentansprüche

1. Verfahren zur Herstellung einer Zusammensetzung für die Verwendung als Transportmaterial für ein elektronisches Bauteil, wobei das Verfahren folgende Schritte umfasst:
a) Bereitstellen eines ersten organischen Halbleiters;
b) Bereitstellen einer Radikalverbindung;
c) Bereitstellen einer polaren Verbindung, die ein Dipolmoment von wenigstens 6,0 Debye (D) aufweist;
d) Mischen des ersten organischen Halbleiters, der Radikalverbindung und der polaren Verbindung, um die Zusammensetzung zu erhalten.

2. Verfahren nach Anspruch 1, wobei der erste organische Halbleiter ein konjugiertes kleines Molekül oder ein konjugiertes Polymer ist.

3. Verfahren nach Anspruch 1 oder 2, wobei der erste organische Halbleiter Triphenylamin, Thiophen oder Triphenylphosphin umfasst.

4. Verfahren nach einem der vorhergehenden Ansprüche, wobei der erste organische Halbleiter aus der Gruppe ausgewählt ist, die aus 2,2',7,7'-Tetrakis[N,N-di(4-methoxyphenyl)amino]-9,9'-spirobifluoren (Spiro-OMeTAD), Poly[bis(4-phenyl)(2,4,6-trimethylphenyl)amin] (PTAA), Poly(3-hexylthiophen) (P3HT), 3,3'-(2,7-Bis(bis(4-methoxyphenyl)amino)-9H-fluoren-9,9-diyl)bis(N-ethyl-N,N-dimethylpropan-1-aminium)bis(trifluormethansulfonyl)imid (X44), Octakis(4-methoxyphenyl)spiro[fluoren-9,9'-xanthen]-2,2',7,7'-tetraamin) (X60), Indacenodithienothiophen-Methoxytriphenylamin (IDTT-TPA), Poly[N-90-heptadecanyl-2,7carbazol-alt-3,6-bis(thiophen-5-yl)-2,5-dioctyl-2,5-dihydropyrrolo[3,4]pyrrol-1,4-dion] (PCBTDPP), Phenyldipyenylphosphinoxid (POPy2) und Gemischen davon besteht.

5. Verfahren nach einem der vorhergehenden Ansprüche, wobei die Radikalverbindung ein Radikalkationenpaar ist, das als R₁^{a•+}(I₁^{b-})_{c} abgekürzt wird, wobei a = b·c, wobei a und b Valenzstufen sind, R₁^{a•+} ein Radikalkation eines zweiten organischen Halbleiters ist und I₁^{b-} ein erstes Gegenanion ist.

6. Verfahren nach Anspruch 5, wobei das erste Gegenanion aus der Gruppe ausgewählt ist, die aus Halogen-Anionen (X⁻), dem Bis(trifluormethylsulfonyl)imid-Anion (TFSI⁻), Hexafluorphosphat (PF₆⁻), Tetrafluorborat (BF₄⁻), Triflat (CF₃SO₃⁻) und Gemischen davon besteht.

7. Verfahren nach einem der Ansprüche 1 - 4, wobei die Radikalverbindung eine Radikalverbindung auf Basis von Triarylamin (TAA) ist.

8. Verfahren nach einem der Ansprüche 1 - 4, wobei die Radikalverbindung ein Radikalanionenpaar ist, das als R₂^{d•-}(I₂^{e+})_{f} abgekürzt wird, wobei d = e·f, wobei d und e Valenzstufen sind, R₂^{d•-} ein Radikalanion eines dritten organischen Halbleiters ist und I₂^{e+} ein erstes Gegenkation ist.

9. Verfahren nach einem der vorhergehenden Ansprüche, wobei die polare Verbindung ein organisches Salz, ein inneres Salz oder ein neutrales polares Molekül ist.

10. Verfahren nach Anspruch 9, wobei das organische Salz ein kleines organisches Molekül, ein mehrwertiges organisches Salz oder ein Polymer-Elektrolyt ist.

11. Verfahren nach Anspruch 10, wobei das organische Salz als (A^{x+})_{y}(B^{z-})_{w} abgekürzt wird, wobei x·y = w·z, wobei x und z Valenzstufen sind, A^{x+} ein zweites Kation ist und B^{z-} ein zweites Anion ist.

12. Verfahren nach Anspruch 11, wobei das zweite Kation A^{x+} ein Alkyl oder ein aromatisches organisches Kation ist.

13. Zusammensetzung für die Verwendung als Transportmaterial für ein elektronisches Gerät, wobei die Zusammensetzung gemäß dem Verfahren nach einem der vorhergehenden Ansprüche hergestellt wird.

14. Transportschicht für ein elektronisches Gerät, wobei die Transportschicht eine Zusammensetzung nach Anspruch 13 umfasst.

15. Elektronisches Gerät, das wenigstens eine Transportschicht nach Anspruch 14 umfasst.

## Revendications

1. Procédé de fabrication d'une composition destinée à être utilisée en tant que matériau de transport d'un dispositif électronique, ledit procédé comprenant les étapes suivantes :
a) la fourniture d'un premier semi-conducteur organique ;
b) la fourniture d'un composé radicalaire ;
c) la fourniture d'un composé polaire présentant un moment dipolaire d'au moins 6,0 debye (D) ;
d) le mélange dudit premier semi-conducteur organique, dudit composé radicalaire et dudit composé polaire pour obtenir ladite composition.

2. Procédé selon la revendication 1, dans lequel ledit premier semi-conducteur organique est une petite molécule conjuguée ou un polymère conjugué.

3. Procédé selon la revendication 1 ou la revendication 2, dans lequel ledit premier semi-conducteur organique comprend de la triphénylamine, du thiophène ou de la triphénylphosphine.

4. Procédé selon l'une quelconque des revendications précédentes, dans lequel ledit premier semi-conducteur organique est choisi dans le groupe constitué par du 2,2',7,7'-tétrakis[N,N-di(4-méthoxyphényl)amino]-9,9'-spirobifluorène (Spiro-OMeTAD), de la poly[bis(4-phényl)(2,4,6-triméthylphényl)amine] (PTAA), du poly(3-hexylthiophène) (P3HT), du 3,3'-(2,7-bis(bis(4-méthoxyphényl)amino)-9H-fluorène-9,9-diyl)bis(N-éthyl-N,N-diméthylpropan-1-aminium) bis(trifluorométhanesulfonyl)imide (X44), de l'octakis(4-méthoxyphényl)spiro[fluorène-9,9'-xanthène]-2,2',7,7'-tétraamine) (X60), de l'indacénodithiénothiophène-méthoxytriphénylamine (IDTT-TPA), de la poly[N-90-heptadécanyl-2,7-carbazole-alt-3,6-bis(thiophène-5-yl)-2,5-dioctyl-2,5-dihydropyrrolo[3,4]pyrrole-1,4-dione] (PCBTDPP), de l'oxyde de phényl-diphénylphosphine (POPy2) et de leurs mélanges.

5. Procédé selon l'une quelconque des revendications précédentes, dans lequel ledit composé radicalaire est une paire cationique radicalaire désignée par l'abréviation R₁^{a•+}(I₁^{b-})_{c}, dans lequel a = b·c, dans lequel a et b représentent des états de valence, R₁^{a•+} est un cation radicalaire d'un deuxième semi-conducteur organique, et I₁^{b-} est un premier contre-anion.

6. Procédé selon la revendication 5, dans lequel ledit premier contre-anion est choisi parmi le groupe constitué des anions halogénés (X⁻), de l'anion bis(trifluorométhylsulfonyl)imide (TFSI⁻), de l'hexafluorophosphate (PF₆⁻), du tétrafluoroborate (BF₄⁻), du triflate (CF₃SO₃⁻) et de leurs mélanges.

7. Procédé selon l'une quelconque des revendications 1 à 4, dans lequel ledit composé radicalaire est un composé radicalaire à base de triarylamine (TAA).

8. Procédé selon l'une quelconque des revendications 1 à 4, dans lequel ledit composé radicalaire est une paire anionique radicalaire désignée par l'abréviation R₂^{d•-}(I₂^{e+})_{f}, dans lequel d = e·f, dans lequel d et e sont des états de valence, R₂^{d•-} est un anion radicalaire d'un troisième semi-conducteur organique, et I₂^{e+} est un premier contre-cation.

9. Procédé selon l'une quelconque des revendications précédentes, dans lequel ledit composé polaire est un sel organique, un sel interne ou une molécule polaire neutre.

10. Procédé selon la revendication 9, dans lequel ledit sel organique est une petite molécule organique, un sel organique multivalent ou un électrolyte polymère.

11. Procédé selon la revendication 10, dans lequel ledit sel organique est désigné par l'abréviation (A^{x+})_{y}(B^{z-})_{w}, dans lequel x·y = w·z, dans lequel x et z sont des états de valence, A^{x+} est un deuxième cation, et B^{z-} est un deuxième anion.

12. Procédé selon la revendication 11, dans lequel ledit deuxième cation A^{x+} est un cation organique alkyle ou aromatique.

13. Composition destinée à être utilisée comme matériau de transport d'un dispositif électronique, ladite composition étant fabriquée selon le procédé selon l'une quelconque des revendications précédentes.

14. Couche de transport pour un dispositif électronique, ladite couche de transport comprenant une composition selon la revendication 13.

15. Dispositif électronique comprenant au moins une couche de transport selon la revendication 14.
